# EUROPÄISCHE PATENTSCHRIFT

(11) **EP 1 072 093 B1**
(45) Veröffentlichungstag und Bekanntmachung des Hinweises auf die Patenterteilung: **08.05.2002**
(21) Anmeldenummer: 98947355.8
(22) Anmeldetag: 28.07.1998
(51) Int. Cl.: H03K 17/082

(54) **SCHALTUNG ZUM ABSCHALTEN EINER MOSFET-ENDSTUFE**
CIRCUIT FOR DE-ACTIVATING A MOS TRANSISTOR OUTPUT STAGE
CIRCUIT POUR LA MISE HORS CIRCUIT D'UN ETAGE FINAL A TRANSISTOR MOS

(30) Priorität: 16.08.1997 DE 19735541
(43) Veröffentlichungstag der Anmeldung: 31.01.2001
(73) Patentinhaber: ROBERT BOSCH GMBH, 70442 Stuttgart (DE)
(72) Erfinder: TOPP, Rainer, D-72768 Reutlingen (DE); MATERNA, Gerald, D-72336 Balingen (DE); STREICHER, Günter, D-72793 Pfullingen (DE); KOELSCH, Volker, D-70599 Stuttgart (DE)
(86) Internationale Anmeldenummer: DE9802131
(87) Internationale Veröffentlichungsnummer: WO9909651

(56) Entgegenhaltungen:
- EP-A- 0 556 663
- EP-A- 0 602 708
- DE-A- 4 236 334
- US-A- 5 642 252

## Beschreibung

Die Erfindung geht aus von einer Schaltung zum Abschalten einer MOSFET-Endstufe nach dem Oberbegriff des Patentanspruchs 1.

Bspw. Bei Smart-Power-Elementen mit High-Side-Endstufe können aufgrund von Störungen anormale Potentiale auf Leitungen auftreten, die zu kritischen Betriebszuständen der MOSFET-Endstufe führen. So kann bspw. ein Signal, das normalerweise auf Massepotential liegen sollte, bedingt elektromagnetische Einstrahlungen oder auch bei Unterbrechung der Masseleitung auf einem höheren Potential liegen. Dies kann dazu führen, daß die MOSFET-Endstufe aktiviert wird, die üblichen Schutzfunktionen für die MOSFET-Endstufe, wie z.B. die Übertemperaturabschaltung, aber nicht voll funktionsfähig sind. Bei Störungen der Übertemperaturabschaltung kann es im Extremfall zur thermischen Zerstörung der Endstufe kommen.

Die EP 0 294 887 beschreibt eine Schaltungsanordnung zum Ansteuern einer MOSFET-Endstufe, wobei ein Ausschalttransistor vorgesehen ist, dessen Funktion außerkraftsetzbar ist.

Die EP 0 602 708 offenbart eine Schaltungsanordnung zur Ansteuerung eines Leistungstransistors mit Mitteln zur Überwachung einer internen Masseleitung.

### Vorteile der Erfindung

Die erfindungsgemäße Schaltung zum Abschalten einer MOSFET-Endstufe umfaßt demgegenüber neben Mitteln zum Steuern der MOSFET-ENDSTUFE - die im folgenden als Systemlogik bezeichnet werden - Mittel zum Überwachen einer oder mehrerer Leitungen - die im folgenden als Detektionslogik bezeichnet werden, wobei die Detektionslogik so ausgelegt ist, daß sie nicht nur das Auftreten anormaler Potentiale auf den überwachten Leitungen erkennt, sondern in diesem Falle auch die MOSFET Endstufe unabhängig von der Systemlogik ausschaltet. Mit der Detektionslogik wird also zusätzlich zu der im Rahmen der Systemlogik vorgesehenen Abschaltungsmöglichkeit eine weitere Abschaltungsmöglichkeit realisiert, von der lediglich beim Auftreten von anormalen Potentialen auf von der Detektionslogik überwachten Leitungen Gebrauch gemacht wird. Die erfindungsgemäße Schaltung verfügt dabei mit der Detektionslogik über einen Bipolartransistor aufweisende Mittel zum Vergleichen des Potentials der überwachten Leitung mit einem Vergleichspotential. Wenn die Abweichung zwischen dem Potential der überwachten Leitung und dem Vergleichspotential ein vorbestimmtes Maß überschreitet, wird die MOSFET-Endstufe über die Detektionslogik ausgeschaltet.

In einer schaltungstechnisch besonders einfachen Variante der erfindungsgemäßen Schaltung ist die Detektionslogik so mit der MOSFET-Endstufe verbunden, daß sie zum Abschalten der MOSFET-Endstufe einfach Gate und Source der MOSFET-Endstufe kurzschließt.

Grundsätzlich gibt es verschiedene Möglichkeiten, wie die Detektionslogik das Vorliegen eines anormalen Potentials auf einer überwachten Leitung feststellen kann.

In einer vorteilhaften Variante der erfindungsgemäßen Schaltung verfügt die Detektionslogik über Mittel zum Überwachen des Stroms zwischen der überwachten Leitung und einem definierten Potential. Hier wird die MOSFET-Endstufe durch die Detektionslogik immer dann ausgeschaltet, wenn der Strom einen vorbestimmten Wert über- bzw. unterschreitet. In einer besonders vorteilhaften Variante der erfindungsgemäßen Schaltung ist die Detektionslogik so ausgelegt, daß die MOSFET-Endstufe nach einem Ausschalten durch die Detektionslogik erst nach einer gewissen Verzögerung wieder freigegeben wird, d.h. wieder eingeschaltet werden kann. Dadurch kann ein hochfrequentes Ein-/Ausschalten der MOSFET-Endstufe beim Auftreten von oszillierenden Potentialen auf der überwachten Leitung, bspw. bedingt durch EMV-Einstrahlung, vermieden werden.

Des weiteren ist es von Vorteil, wenn die Detektionslogik Mittel umfaßt, mit denen sich die Ausschaltfunktion für die MOSFET-Endstufe beim Auftreten von Überspannungen außer Kraft setzen läßt. Dadurch können Überspannungen über die Endstufe abgebaut werden.

### Zeichnungen

Es gibt nun verschiedene Möglichkeiten für die schaltungstechnische Realisierung der voranstehend angegebenen einzelnen Funktionen der Detektionslogik. Besonders vorteilhafte Ausführungsformen der Erfindung sind in den Zeichnungen dargestellt und in der nachfolgenden Beschreibung näher erläutert. Es zeigen
- Fig. 1: den prinzipiellen Aufbau einer erfindungsgemäßen Schaltung zum Abschalten einer MOSFET-Endstufe,
- Fig. 2: ein Ausführungsbeispiel einer Detektionslogik, mit der die chipinterne Masseleitung überwacht wird,
- Fig. 3: ein weiteres Ausführungsbeispiel einer Detektionslogik, mit der die chipinteme Masseleitung überwacht wird, und
- Fig. 4: ein Ausführungsbeispiel einer Detektionslogik, mit der ein anderes Signal überwacht wird.

### Beschreibung der Ausführungsbeispiele

Eine besonders vorteilhafte Anwendung der erfindungsgemäßen Schaltung besteht in der Überwachung des internen Massepotentials, d.h. des Massepotentials der Mittel zum Steuern der MOSFET-Endstufe, die nachfolgend als Systemlogik bezeichnet werden. Mit Hilfe der erfindungsgemäßen Schaltung kann so bspw. vermieden werden, daß die MOSFET-Endstufe im Falle eines Masseabrisses thermisch überlastet wird, weil die Übertemperaturabschaltung der Systemlogik nicht mehr voll funktionsfähig ist.

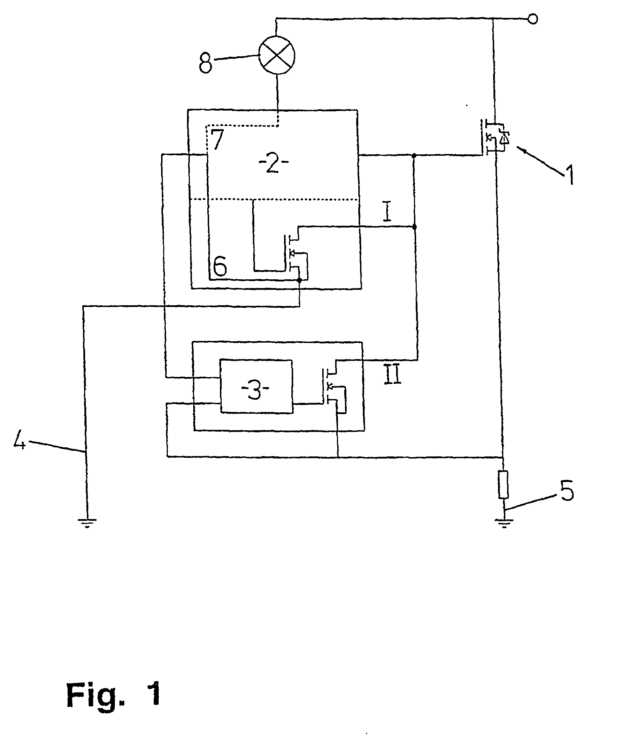

Figur 1 zeigt die wesentlichen Bestandteile einer erfindungsgemäßen Schaltung und deren Zusammenwirken. Eine MOSFET-Endstufe, die hier in Form eines Power-Mos 1 realisiert ist, wird über eine Systemlogik 2 gesteuert, die die üblichen Ansteuer- und Schutzschaltungen sowie anwendungsspezifische Funktionen enthält. Der Power-Mos 1 kann durch die Systemlogik 2 über den Abschaltpfad I abgeschaltet werden, indem das Gate des Power-Mos 1 nach Masse, und zwar auf das chipinterne Massepotential, geschaltet wird. Kommt es in dieser Konfiguration zu einer Anhebung des chipinternen Massepotentials, bspw. durch EMV-Einstrahlung oder Leitungsabriß, so ist ein eindeutiges Abschalten des Power-Mos 1 nicht mehr gewährleistet.

Erfindungsgemäß umfaßt die hier dargestellte Schaltung daher Mittel 3 zum Überwachen der chipinternen Masseleitung 4, die im folgenden als Detektionslogik 3 bezeichnet werden. Erkennt die Detektionslogik 3 ein anormales Potential auf der Masseleitung 4, so veranlaßt sie die Abschaltung des Power-Mos 1. Dazu werden Gate und Source des Power-Mos 1 über den Abschaltpfad II kurzgeschlossen. Die Überwachung der Masseleitung 4 erfolgt hier durch Vergleich des Potentials der Masseleitung 4 mit einem Referenzsignal, nämlich dem Potential eines externen Masseanschlusses 5. Liegt das Potential der überwachten Masseleitung 4 um ein bestimmtes Maß über dem Referenzpotential, dann wird der Power-Mos 1 abgeschaltet.

Die Detektionslogik 3 ist außerdem so ausgelegt, daß der Power-Mos 1 nach einem Abschalten durch die Detektionslogik 3 erst wieder nach einer gewissen Verzögerung freigegeben wird. Dadurch läßt sich ein hochfrequentes Ein/Ausschalten des Power-Mos 1 bedingt durch oszillierende Potentiale auf der chipinternen Masseleitung 4 vermeiden.

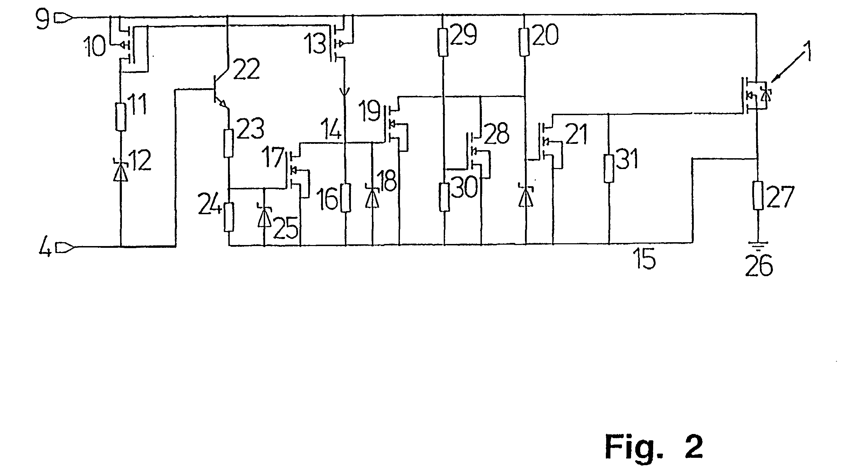

Figur 2 zeigt nun die schaltungstechnische Realisierung einer Detektionslogik, mit der die chipinterne Masseleitung 4 überwacht wird. Diese Leitungsverbindung ist in Figur 1 mit 6 gekennzeichnet. Die MOSFET-Endstufe, die im Falle von anormalen Potentialen auf der chipinternen Masseleitung 4 durch die Detektionslogik ausgeschaltet werden soll, ist in Figur 2 genauso wie in Figur 1 mit 1 bezeichnet.

Zwischen der positiven Versorgung 9 und der Chipmasse 4 sind die Elemente MOSFET 10, Widerstand 11 und Diode 12 angeordnet. Diese bilden zusammen mit dem MOSFET 13 einen Stromspiegel, über den am Punkt 14 ein Strom eingespeist wird. Zwischen dem Punkt 14 und dem Source-Anschluß der MOSFET-Endstufe 1 bzw. dem Lastausgang 15 befinden sich die Elemente Widerstand 16, MOSFET 17 und Schutzdiode 18. Die Spannung zwischen dem Punkt 14 und dem Lastausgang 15 bestimmt den Schaltzustand eines MOSFET 19, dessen Drain-Anschluß mit einem Pull-Up-Widerstand 20 und dem Gate eines MOSFET 21 verbunden ist. Der MOSFET 21 liegt zwischen Gate und Source der MOSFET-Endstufe 1. Die Ansteuerung des MOSFET 17 erfolgt über einen Bipolar-Transistor 22 und einen Spannungsteiler, der durch die Widerstände 23 und 24 und die Diode 25 gebildet ist. Der Basisanschluß des Bipolar-Transistors 22 ist mit dem zu überwachenden Potential, hier der Masseleitung 4, verbunden.

In diesem Zusammenhang sei angemerkt, daß mit der in Figur 2 dargestellten Schaltung auch mehrere Leitungen überwacht werden können, indem mehrere Transistoren 22 parallel geschaltet werden. Die Basisanschlüsse dieser Transistoren 22 müssen dann mit den verschiedenen zu überwachenden Leitungen verbunden werden.

Nachfolgend wird die Funktionsweise der in Figur 2 dargestellten Schaltung näher erläutert.

Im AUS-Zustand fließt über eine zwischen dem Lastausgang 15 und einem externen Masseanschluß 26 liegende Last 27 kein Strom, so daß der Lastausgang 15 auf Massepotential liegt. Wird nun durch einen äußeren Einfluß, bspw. durch Abriß der chipinternen Masseleitung 4 oder durch elektromagnetische Einstrahlung, das hier überwachte chipinterne Massepotential angehoben, so wird der Bipolar-Transistor 22 eingeschaltet. Infolge wird auch der MOSFET 21 über die MOSFETs 17 und 19 und über den Widerstand 20 eingeschaltet. Dadurch kann die MOSFET-Endstufe 1 nicht eingeschaltet werden. Die Ansteuerung des MOSFET 17 über den Bipolar-Transistor 22 und den Spannungsteiler in Form der Widerstände 23 und 24 und der Diode 25 ist so dimensioniert, daß der MOSFET 17 zwar schnell eingeschaltet werden kann, aber aufgrund eines Gleichrichtereffekts nur verzögert ausgeschaltet wird. Dazu ist der Widerstand 23 wesentlich kleiner dimensioniert als der Widerstand 24. Bei Anhebung des chipinternen Massepotentials wird außerdem der Strom zwischen dem MOSFET 13 und dem Widerstand 16 reduziert bzw. abgeschaltet, wodurch das Abschalten des MOSFET 19 und damit das Einschalten des MOSFET 21 unterstützt wird.

Mit Hilfe des MOSFET 28 und der Widerstände 29 und 30 wird der MOSFET 21 im Falle einer hohen Versorgungsspannung ausgeschaltet, so daß Überspannungen über die MOSFET-Endstufe 1 abgebaut werden können. Außerdem kann dann eine Schutzschaltung gegenüber Spannungsimpulsen ansprechen.

Tritt ein Masseabriß im EIN-Zustand auf, so wird das chipinterne Massepotential aufgrund der übrigen Schaltungselemente zwischen der Versorgungsspannung 9 und dem chipinternen Masseanschluß 4 angehoben. In diesem Falle wird das Gate der MOSFET-Endstufe 1 über den MOSFET 21 und einen Widerstand 31 entladen. Dadurch sinkt das Potential am Lastausgang 15 unter das chipinterne Massepotential ab, was - wie voranstehend beschrieben - zu einer Abschaltung der MOSFET-Endstufe 1 führt.

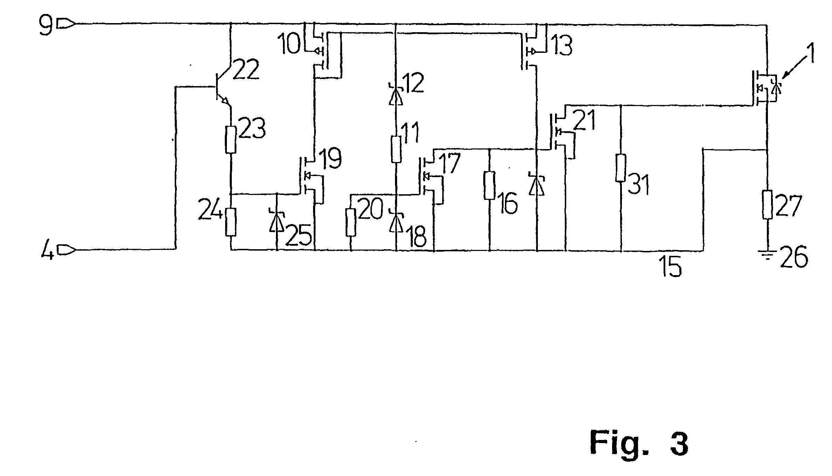

Die in Figur 3 dargestellte Schaltungsanordnung unterscheidet sich von der in Figur 2 dargestellten Schaltungsanordnung im wesentlichen nur durch die Plazierung des Stromspiegels. Durch die Verlagerung des Stromspiegels hinter den Bipolar-Transistor 22 ist hier im Gegensatz zu der in Figur 2 dargestellten Schaltung kein Ruhestrom erforderlich.

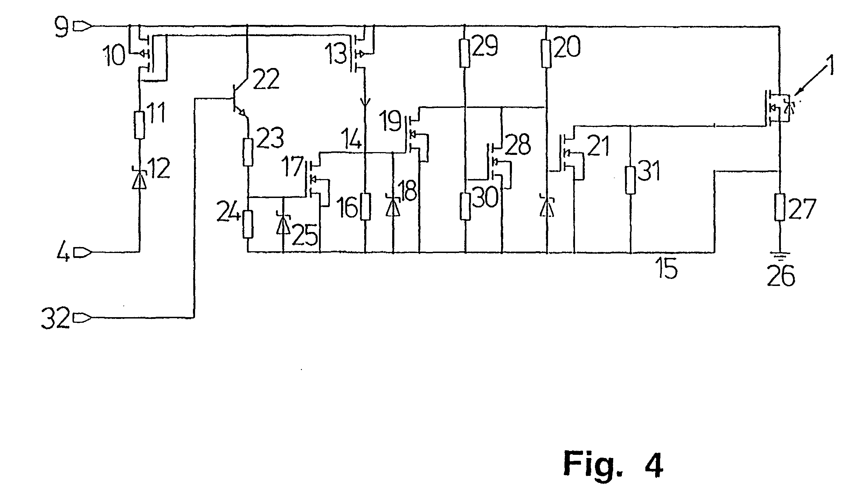

Figur 4 verdeutlicht, daß die in Figur 2 dargestellte Schaltungsanordnung nicht nur zu Überwachung der chipinternen Masseleitung 4 geeignet ist, sondern auch zur Überwachung anderer Leitungen 32 verwendet werden kann. Dies könnte z.B. die in Figur 1 gestrichelt gezeichnete Verbindung zu einem Lampentreiber 8 sein, die in Figur 1 mit 7 gekennzeichnet ist.

Die voranstehend erörterten Ausführungsbeispiele zeigen, daß mit der erfindungsgemäß vorgeschlagenen Schaltung ergänzend zu dem von der Systemlogik realisierten Abschaltpfad eine zusätzliche von der Systemlogik unabhängige Abschaltmöglichkeit für eine MOSFET-Endstufe zur Verfügung steht. Von dieser zusätzlichen Abschaltmöglichkeit soll nur Gebrauch gemacht werden, wenn auf einer von einer Detektionslogik überwachten Leitung kritische Potentiale auftreten. Die Detektionslogik gewährleistet ein schnelles Abschalten der MOSFET-Endstufe. Zusätzlich kann die Detektionslogik noch so ausgestaltet sein, daß eine Verzögerung in der Freigabe der MOSFET-Endstufe nach einem Abschalten durch die Detektionslogik realisiert wird. Diese Gleichrichterwirkung der Detektionslogik verhindert einen aktiven Betrieb der MOSFET-Endstufe, wenn oszillierende Potentiale auf der überwachten Leitung auftreten. Außerdem kann die Detektionslogik noch so ausgelegt sein, daß ihre Abschaltfunktion für die MOSFET-Endstufe außer Kraft gesetzt wird, wenn Überspannungsimpulse auf den Zuleitungen auftreten.

## Patentansprüche

1. Schaltung zum Abschalten einer MOSFET-Endstufe (1), insbesondere eines High-Side-PowerMos, beim Auftreten anormaler Potentiale auf mindestens einer überwachten Leitung, wobei mindestens eine Einrichtung (2) zum Steuern der MOSFET-Endstufe (1), insbesondere eine Ansteuerlogik mit einer Schutzschaltung gegen Übertemperatur und/oder Überlastung, und mindestens eine weitere Einrichtung (3) zum Überwachen der Leitung vorgesehen sind, wobei die MOSFET-Endstufe (1) unabhängig von der mindestens einen Einrichtung (2) zum Steuern der MOSFET-Endstufe (1) auch über die mindestens eine weitere Einrichtung (3) zum Überwachen der Leitung ausschaltbar ist, wobei die Leitung eine elektrische Verbindung zwischen einem Pol der Versorgungsspannung der Einrichtung (2), insbesondere chipinternem Massepotential oder Versorgungsspannungspotential, und der mindestens einen Einrichtung (2) bildet und durch die mindestens eine weitere Einrichtung (3) die Schaltung vor Fehlfunktionen der mindestens einen Einrichtung (2) geschützt wird, wobei
die weitere Einrichtung (3) zum Überwachen der mindestens einen Leitung (4) Mittel zum Vergleichen des Potentials der überwachten Leitung (4) mit einem Vergleichspotential umfaßt und die weitere Einrichtung (3) zum Überwachen der Leitung (4) die MOSFET-Endstufe (1) ausschaltet, wenn die Abweichung zwischen dem Potential der überwachten Leitung (4) und dem Vergleichspotential ein vorbestimmtes Maß überschreitet, dadurch gekennzeicknet, daß
die Mittel zum Überwachen der mindestens
einen Leitung (4, 32) mindestens einen Bipolartransistor (22) umfassen und der Basisanschluß des Bipolartransistors (22) mit der überwachten Leitung (4, 32) verbunden ist und der Emitter des Bipolartransistors (22) über mindestens einen elektrischen Widerstand (23, 24) mit dem Vergleichspotential verbunden ist.

2. Schaltung nach Anspruch 1, **dadurch gekennzeichnet, daß** die MOSFET-Endstufe (1) über die weitere Einrichtung (3) zum Überwachen der Leitung (4) ausgeschaltet wird, indem Gate und Source der MOSFET-Endstufe (1) kurzgeschlossen werden (Abschaltpfad II).

3. Schaltung nach einem der Ansprüche 1 bis 2, **dadurch gekennzeichnet, daß** die weitere Einrichtung (3) zum Überwachen der mindestens einen Leitung (4) Mittel umfassen, mit denen das Wiedereinschalten der MOSFET-Endstufe (1) nach einem Ausschalten durch die weitere Einrichtung (3) zum Überwachen der Leitung (4) verzögert wird.

4. Schaltung nach einem der Ansprüche 1 bis 3, **dadurch gekennzeichnet, daß** die weitere Einrichtung (3) zum Überwachen der mindestens einen Leitung (4) Mittel zum Überwachen des Stroms zwischen der überwachten Leitung (4) und einem definierten Potential umfassen und daß die weitere Einrichtung (3) zum Überwachen der Leitung (4) die MOSFET-Endstufe (1) ausschaltet, wenn der Strom einen vorbestimmten Wert über- bzw. unterschreitet.

5. Schaltung nach einem der Ansprüche 1 bis 4, **dadurch gekennzeichnet, daß** die weitere Einrichtung (3) zum Überwachen der mindestens einen Leitung (4) Mittel umfaßt zum Außerkraftsetzen der Ausschaltfunktion für die MOSFET-Endstufe (1) beim Auftreten von Überspannungen.

6. Schaltung nach einem der Ansprüche 1 bis 5, **dadurch gekennzeichnet, daß** die Mittel zum Überwachen der mindestens einen Leitung (4) einen ersten MOSFET (21) umfassen, über den Gate und Source der MOSFET-Endstufe (1) kurzschließbar sind.

7. Schaltung nach einem der Ansprüche 1 bis 6, wobei mehrere Leitungen überwacht werden, **dadurch gekennzeichnet, daß** die Mittel zum Überwachen jeder Leitung mindestens einen Bipolartransistor umfassen und daß die Bipolartransistoren parallel geschaltet sind.

8. Schaltung nach einem der Ansprüche 1 bis 7, **dadurch gekennzeichnet, daß** der Emitteranschluß des Bipolartransistors (22) über eine Spannungsteileranordnung (23, 24, 25) mit einem zweiten MOSFET (17) verbunden ist, wobei der Schaltzustand des zweiten MOSFET (17) den Schaltzustand des ersten MOSFET (21) beeinflußt, und daß die Spannungsteileranordnung (23, 24, 25) so dimensioniert ist, daß der zweite MOSFET (17) schnell einschaltbar aber nur verzögert ausschaltbar ist.

9. Schaltung nach Anspruch 8, **dadurch gekennzeichnet, daß** zwischen der überwachtend Leitung (4, 32) und einem definierten Potential ein dritter MOSFET (10) angeordnet ist, wobei der Schaltzustand des dritten MOSFET (10) vom Strom zwischen der überwachten Leitung (4, 32) und dem definierten Potential abhängig ist und den Schaltzustand des ersten MOSFET (21) beeinflußt.

10. Verwendung einer Schaltung nach einem der Ansprüche 1 bis 11 zur Überwachung einer chipinternen Masseleitung (4).

## Claims

1. Circuit for shutdown of a MOSFET output stage (1), in particular of a high-side powerMos, when abnormal potentials occur on at least one monitored line, provision being made of at least one device (2) for controlling the MOSFET output stage (1), in particular a drive logic unit with a protective circuit against overtemperature and/or overload, and at least one further device (3) for monitoring the line, the MOSFET output stage (1), independently of the at least one device (2) for controlling the MOSFET output stage (1), also being able to be switched off via the at least one further device (3) for monitoring the line, the line forming an electrical connection between one pole of the supply voltage of the device (2), in particular on-chip earth potential or supply voltage potential, and the at least one device (2), and the at least one further device (3) protecting the circuit against mulfunctions of the at least one device (2), the further device (3) for monitoring the at least one line (4) comprising means for comparing the potential of the monitored line (4) with a comparison potential, and the further device (3) for monitoring the line (4) switching the MOSFET output stage (1) off if the deviation between the potential of the monitored line (4) and the comparison potential exceeds a predetermined amount,
**characterized in that** the means for monitoring the at least one line (4, 32) comprise at least one bipolar transistor (22) and the base terminal of the bipolar transistor (22) is connected to the monitored line (4, 32) and the emitter of the bipolar transistor (22) is connected to the comparison potential via at least one electrical resistor (23, 24).

2. Circuit according to Claim 1, **characterized in that** the MOSFET output stage (1) is switched off via the further device (3) for monitoring the line (4) by the gate and source of the MOSFET output stage (1) being short-circuited (shutdown path II).

3. Circuit according to either of Claims 1 and 2, **characterized in that** the further device (3) for monitoring the at least one line (4) comprises means which delay the process of switching the MOSFET output stage (1) on again after a process of switching off by the further device (3) for monitoring the line (4).

4. Circuit according to one of Claims 1 to 3, **characterized in that** the further device (3) for monitoring the at least one line (4) comprises means for monitoring the current between the monitored line (4) and a defined potential, and **in that** the further device (3) for monitoring the line (4) switches the MOSFET output stage (1) off if the current exceeds or falls below a predetermined value.

5. Circuit according to one of Claims 1 to 4, **characterized in that** the further device (3) for monitoring the at least one line (4) comprises means for deactivating the switch-off function for the MOSFET output stage (1) when overvoltages occur.

6. Circuit according to one of Claims 1 to 5, **characterized in that** the means for monitoring the at least one line (4) comprise a first MOSFET (21), via which the gate and source of the MOSFET output stage (1) can be short-circuited.

7. Circuit according to one of Claims 1 to 6, a plurality of lines being monitored, **characterized in that** the means for monitoring each line comprise at least one bipolar transistor, and **in that** the bipolar transistors are connected in parallel.

8. Circuit according to one of Claims 1 to 7, **characterized in that** the emitter terminal of the bipolar transistor (22) is connected to a second MOSFET (17) via a voltage divider arrangement (23, 24, 25), the switching state of the second MOSFET (17) including the switching state of the first MOSFET (21), and **in that** the voltage divider arrangement (23, 24, 25) is dimensioned in such a way that the second MOSFET (17) can be switched on rapidly but can be switched off only with a delay.

9. Circuit according to Claim 8, **characterized in that** a third MOSFET (10) is arranged between the monitored line (4, 32) and a defined potential, the switching state of the third MOSFET (10) being dependent on the current between the monitored line (4, 32) and the defined potential and influencing the switching state of the first MOSFET (21).

10. Use of a circuit according to one of Claims 1 to 11 for monitoring an on-chip earth line (4).

## Revendications

1. Circuit pour couper un étage de puissance MOSFET (1) notamment un MOSFET de puissance côté haut, lorsque se produisent des potentiels anormaux sur au moins une ligne à surveiller, selon lequel il est prévu au moins une installation (2) pour commander l'étage de puissance MOSFET (1), notamment une logique de commande avec un circuit de protection contre les surtempératures et/ou les surcharges et au moins une autre installation (3) pour surveiller la ligne, l'étage de puissance MOSFET (1) pouvant être coupé indépendamment d'au moins l'installation (2) pour commander l'étage de puissance MOSFET (1) également par au moins l'autre installation (3) pour surveiller la ligne, la ligne forme une liaison électrique entre un pôle de la tension d'alimentation de l'installation (2), notamment le potentiel de masse interne à une puce ou le potentiel de tension d'alimentation, et au moins l'installation (2), et le circuit est protégé par au moins l'autre installation (3) contre les défauts de fonctionnement d'au moins l'installation (2), l'autre installation (3) pour surveiller au moins une ligne (4) comportant des moyens pour comparer le potentiel de la ligne à surveiller (4) à un potentiel de comparaison, et l'autre installation (3) pour surveiller la ligne (4) coupant l'étage de puissance MOSFET (1) si la différence entre le potentiel de la ligne à surveiller (4) et le potentiel de comparaison dépasse une valeur donnée,
**caractérisé en ce que**
les moyens pour surveiller au moins la ligne (4, 32) comprennent au moins un transistor bipolaire (22), le branchement de la base du transistor bipolaire (22) étant relié à la ligne surveillée (4, 32) et l'émetteur du transistor bipolaire (22) étant relié par au moins une résistance électrique (23, 24) au potentiel de comparaison.

2. Circuit selon la revendication 1,
**caractérisé en ce que**
l'étage de puissance MOSFET (1) est coupé par l'autre installation (3) pour surveiller la ligne (4) par la mise en court-circuit de la porte et de la source de l'étage de puissance MOSFET (1) (chemin de coupure II).

3. Circuit selon l'une des revendications 1 et 2,
**caractérisé en ce que**
l'autre installation (3) pour surveiller au moins la ligne (4) comprend des moyens à l'aide desquels le rebranchement de l'étage de puissance MOSFET (1) après une coupure par l'autre installation (3) est temporisé pour surveiller la ligne (4).

4. Circuit selon l'une quelconque des revendications 1 à 3,
**caractérisé en ce que**
l'autre installation (3) pour surveiller au moins la ligne (4) comprend des moyens pour surveiller le courant entre la ligne surveillée (4) et un potentiel défini, et
l'autre installation (3) pour surveiller la ligne (4) coupe l'étage de puissance MOSFET (1) si le courant dépasse vers le haut ou vers le bas une valeur prédéterminée.

5. Circuit selon l'une quelconque des revendications 1 à 4,
**caractérisé en ce que**
l'autre installation (3) pour surveiller au moins la ligne (4) comprend des moyens pour mettre hors service la fonction de coupure de l'étage de puissance MOSFET (1) lorsque se produisent des surtensions.

6. Circuit selon l'une quelconque des revendications 1 à 5,
**caractérisé en ce que**
les moyens de surveillance d'au moins la ligne (4) comprennent un premier transistor MOSFET (21) permettant de court-circuiter la porte et la source de l'étage de puissance MOSFET (1).

7. Circuit selon l'une quelconque des revendications 1 à 6, avec surveillance de plusieurs lignes,
**caractérisé en ce que**
les moyens pour surveiller chaque ligne comprennent au moins un transistor bipolaire et ces transistors bipolaires sont branchés en parallèle.

8. Circuit selon l'une quelconque des revendications 1 à 7,
**caractérisé en ce que**
le branchement d'émetteur du transistor bipolaire (22) est relié par un diviseur de tension (23, 24, 25) à un second MOSFET (17) et l'état de commutation du second MOSFET (17) influence l'état de commutation du premier MOSFET (21), et
le diviseur de tension (23, 24, 25) est dimensionné pour que le second MOSFET (17) puisse être branché rapidement, mais seulement coupé avec temporisation.

9. Circuit selon la revendication 8,
**caractérisé en ce qu'**
entre la ligne qui surveille (4, 32) et un potentiel défini, on a un troisième MOSFET (10), l'état de commutation de ce troisième MOSFET (10) dépendant du courant entre la ligne surveillée (4, 32) et le potentiel défini, et influençant l'état de commutation du premier MOSFET (21).

10. Application d'un circuit selon l'une quelconque des revendications 1 à 11, pour surveiller une ligne de masse (4) interne à une puce.
